# EUROPÄISCHE PATENTSCHRIFT

(11) **EP 2 378 580 B1**
(45) Veröffentlichungstag und Bekanntmachung des Hinweises auf die Patenterteilung: **11.05.2016**
(21) Anmeldenummer: 11156785.5
(22) Anmeldetag: 03.03.2011
(51) Int. Cl.: H01L 41/257

(54) **Verfahren zum Heißpolarisieren eines piezokeramischen Bauelements**
Method for thermal polarisation of a piezo-ceramic device
Procédé de polarisation à chaud d'un dispositif piézocéramique

(30) Priorität: 29.11.2010 DE 102010062112; 16.04.2010 DE 102010027848
(43) Veröffentlichungstag der Anmeldung: 19.10.2011
(73) Patentinhaber: Robert Bosch GmbH, 70442 Stuttgart (DE)
(72) Erfinder: Koellein, Robert, 16321 Bernau (DE)

(56) Entgegenhaltungen:
- EP-A2- 0 350 941
- DE-A1-102004 024 120
- DE-B3- 10 338 486
- JP-A- H01 196 878
- US-A1- 2009 236 949
- KOUNGA ALAIN ET AL: "High-temperature poling of ferroelectrics", JOURNAL OF APPLIED PHYSICS, AMERICAN INSTITUTE OF PHYSICS, 2 HUNTINGTON QUADRANGLE, MELVILLE, NY 11747, Bd. 104, Nr. 2, 30. Juli 2008 (2008-07-30) , Seiten 24116-24116, XP012117004, ISSN: 0021-8979, DOI: 10.1063/1.2959830

## Beschreibung

### Stand der Technik

Die Erfindung betrifft ein Verfahren zum Heißpolarisieren eines piezokeramischen Bauelements und ein piezokeramisches Bauelement, insbesondere einen piezoelektrischen Aktor, der mit solch einem Verfahren heißpolarisiert worden ist.

Aus der DE 100 62 672 A1 sind ein piezoelektrisches Bauelement und ein Verfahren zur Herstellung eines piezoelektrischen Bauelements bekannt. Hierbei umfasst das Verfahren zur Herstellung des Bauelements mehrere Schritte. Hierbei wird ein Stapel von einem Binder enthaltenden keramischen Grünfolien und Elektrodenschichten durch Stapeln und anschließendes Laminieren der Grünfolien beziehungsweise Elektrodenschichten hergestellt.
Ein piezoelektrisches Bauelement, dessen Herstellung aus der DE 100 62 672 A1 bekannt ist, kann als Wandler dienen, der eine angelegte Spannung entsprechend dem piezoelektrischen Effekt in eine Längenänderung beziehungsweise eine mechanische Kraft umwandelt. Eine mögliche Anwendung für solch einen Wandler besteht als Aktor in Brennstoffeinspritzsystemen im Automobilbau. Allerdings sind auch andere Einsatzmöglichkeiten zur Energieumwandlung, nämlich von elektrischer Energie in mechanische Energie und umgekehrt, möglich.

Vor dem Einsatz des piezoelektrischen Bauelements muss dieses polarisiert werden. Hierbei ist es denkbar, dass während des Herstellungsverfahrens ein Prozessschritt durchgeführt wird, bei dem ein Heißpolarisieren erfolgt. Das Heißpolarisieren hat dabei den Zweck, den piezoelektrischen Effekt in dem piezokeramischen Material, insbesondere einer Keramik aus Bleizirkonat-Titanat nutzbar zu machen. Hierfür ist es erforderlich, dass die Dipolmomente durch das Anlegen eines elektrischen Feldes in eine Vorzugsrichtung ausgelenkt werden. Nach diesem Prozess weist die Keramik eine remanente Polarisation und eine remanente Dehnung auf. Die Domänen haben dann eine Vorzugsrichtung und sind nicht mehr statistisch verteilt. Da mit steigender Temperatur die Domänenbeweglichkeit zunimmt, erfolgt die Polarisation in vorteilhafter Weise bei erhöhter Temperatur im Heißpolarisieren.
Bei einer denkbaren Auslegung des Heißpolarisierens wird die Keramik über ihre Curie-Temperatur erhitzt. Oberhalb dieser Temperatur, die eine Phasengrenze darstellt, liegen die Kristalle der Bleizirkonat-Titanat-Keramik im kubischen Raumgitter vor. Die ausrichtbaren Dipolmomente bilden sich erst durch Abkühlen beim Phasenübergang in das rhomboedrische beziehungsweise tetragonale Raumgitter aus. Liegt die Polarisationsspannung bereits beim Phasenübergang in der kubischen Gitterstruktur an, dann können die Dipolmomente bereits im Moment der Ausbildung im rhomboedrischen beziehungsweise tetragonalen Raumgitter ausgerichtet werden. Für eine nachhaltige Polarisation bleibt das elektrische Feld angelegt, bis das Bauelement soweit abgekühlt ist, dass die Domänenbeweglichkeit stark reduziert ist.
Für hohe Temperaturen steigt allerdings die Leitfähigkeit der Piezokeramik expotentiell an. Beim Anlegen der Polarisationsspannung fließt insbesondere oberhalb der Curie-Temperatur neben dem Ladestrom der Kapazität des Bauteils auch ein wesentlich größerer Verluststrom. Um die Keramik nicht zu zerstören, wird der Strom beim Anlegen der Spannung, die unterhalb der Curie-Temperatur die Piezokeramik polarisiert, begrenzt. Hierbei ist eine Einstellung denkbar, bei der die Sollspannung für das Heißpolarisieren bei begrenztem Strom so schnell wie möglich erreicht wird.
Somit besteht beim Heißpolarisieren das Problem, dass die Keramik einen hohen Energieeintrag erfährt, der oberhalb der Curie-Temperatur keinen Beitrag zur Polarisation leisten kann. Die Struktur der Keramik kann hierdurch negativ beeinflusst und auch mechanisch geschädigt werden. Folgen können das Wandern von Sauerstoffleerstellen und ein Domänenwandpinning sein, was die Schaltfähigkeit der Domänen reduziert.
Aus der EP 0 350 941 A2 ist darüber hinaus ein Verfahren zum Heißpolarisieren eines piezokeramischen Bauelements bekannt, bei dem das Bauelement über die Curie-Temperatur erwärmt wird.

### Offenbarung der Erfindung

Das erfindungsgemäße Verfahren mit den Merkmalen des Anspruchs 1 hat demgegenüber den Vorteil, dass das Heißpolarisieren und die Eigenschaften des heißpolarisierten piezokeramischen Materials verbessert sind. Speziell kann ein überflüssiger und schädigender Ladungsträgertransport in dem keramischen Material vor dem eigentlichen Heißpolarisieren reduziert und somit die Qualität des Heißpolprozesses gesteigert werden.

Beim Abkühlen des piezokeramischen Bauelements erfolgt eine geregelte Strombegrenzung auf Grundlage einer Widerstandsüberwachung. Hierbei wird der Strom durch das piezokeramische Bauelement beim Abkühlen zunächst auf einen sehr geringen Wert begrenzt, auf Grundlage des vorgegebenen Stroms und der sich einstellenden Spannung der Widerstand des piezokeramischen Materials bestimmt und, wenn sich durch die Abkühlung des piezokeramischen Bauelements der Widerstand des keramischen Materials auf einen Wert erhöht hat, der exakt oder zumindest annähernd dem Widerstand bei Curie-Temperatur entspricht, der Strom nicht weiter begrenzt.
Vorteilhaft ist es, dass die an das piezoelektrische Material angelegte Spannung in einem vorbestimmten Zeitintervall von einer zumindest näherungsweise verschwindenden Spannung auf die vorgegebene Sollspannung geführt wird. Hierbei kann die Spannung in vorteilhafter Weise zumindest näherungsweise linear ansteigen oder zumindest näherungsweise expotentiell ansteigen, um die vorgegebene Sollspannung zu erreichen. Hierdurch ist eine vorteilhafte Spannungsführung ermöglicht, bei der ein überflüssiger und schädigender Ladungsträgertransport in der Keramik vor dem eigentlichen Heißpolarisieren verringert ist. Hierdurch ist eine optimierte Prozessregelung für das Heißpolarisieren möglich. Hierbei ist das vorbestimmte Zeitintervall, in dem die an das piezoelektrische Material angelegte Spannung von der verschwindenden Spannung auf die vorgegebene Sollspannung geführt wird, beispielsweise etwa 10 Sekunden lang.

Ferner ist es vorteilhaft, dass eine Temperatur des piezokeramischen Bauelements erfasst wird und dass in Abhängigkeit von der erfassten Temperatur des piezoelektrischen Bauelements das Anlegen der Spannung an das piezoelektrische Bauelement gestartet wird. Hierdurch ist eine vorteilhafte Triggerung für den Spannungsanstieg auf die Sollspannung möglich. Vorteilhaft ist es hierbei auch, dass das Anlegen der Spannung an das piezoelektrische Bauelement gestartet wird, wenn die erfasste Temperatur des piezoelektrischen Bauelements eine vorgegebene Temperatur unterschreitet. Die Temperaturmessung kann beispielsweise über einen Temperaturmessfühler erfolgen. Hierbei kann das piezokeramische Bauelement über ein oder mehrere Kontaktstifte kontaktiert sein, wobei in zumindest einen Kontaktstift ein Temperaturmessfühler integriert sein kann, um die Temperatur des piezoelektrischen Bauelements zu erfassen. Hierdurch kann die gewünschte Sollspannung erreicht werden, bevor das piezoelektrische Bauelement die Curie-Temperatur unterschreitet.

Vorteilhaft ist es auch, dass das Abkühlen des piezokeramischen Bauelements eine externe Kühlung umfasst und dass das Anlegen der Spannung an das piezokeramische Material spätestens gestartet wird, wenn die externe Kühlung beginnt. Hierdurch kann eine Zwangskühlung durchgeführt werden. Möglich ist es hierbei, dass der Spannungsanstieg beim Unterschreiten einer Temperatur des piezokeramischen Bauelements, die oberhalb der Curie-Temperatur liegt, aber spätestens mit Einsatz der Zwangskühlung startet. Gegebenenfalls kann hierbei auch der Einsatz der Zwangskühlung verzögert werden. Somit kann die Sollspannung mit geringerem Stromfluss schnell und noch oberhalb der Curie-Temperatur erreicht werden.

Vorteilhaft ist es, dass beim Anlegen der Spannung an das piezokeramische Material eine Strombegrenzung erfolgt. Vorteilhaft ist es auch, dass beim Abkühlen des piezokeramischen Bauelements zunächst eine Strombegrenzung auf einen niedrigen Strombegrenzungswert erfolgt, dass während der Strombegrenzung auf den niedrigen Strombegrenzungswert ein sprunghafter Spannungsanstieg erfasst wird und dass beim Erfassen des sprunghaften Spannungsanstiegs ein Zeitpunkt für einen Anstieg der angelegten Spannung bestimmt wird. Hierdurch ist eine vorteilhafte Triggerung des Anstiegs der angelegten Spannung möglich. Vorteilhaft ist es auch, dass beim Abkühlen des piezokeramischen Bauelements zunächst eine Strombegrenzung auf einen niedrigen Strombegrenzungswert erfolgt und dass ein Beginn einer externen Kühlung des piezokeramischen Bauelements solange verzögert wird, bis die vorgegebene Sollspannung bei der Strombegrenzung auf den niedrigen Strombegrenzungswert erreicht ist. Hierdurch kann gegebenenfalls auf eine Temperaturerfassung verzichtet werden. Stattdessen kann ein Wert bestimmt werden, auf den die Spannung bei einem sehr geringen Strom, beispielsweise einer Begrenzung auf 5 mA oder 10 mA sprunghaft ansteigt. Hierdurch ist ein Rückschluss auf die momentane Temperatur möglich, die als Ersatzgröße zum Triggern des optimalen Zeitpunkts für das Anlegen der Spannung dient.

Darüber hinaus ist es vorteilhaft, dass der Strom durch das piezokeramische Bauelement dann nicht weiter begrenzt wird, wenn eine weitere Begrenzung des Stromes durch den stark gestiegenen Widerstand des piezokeramischen Materials nicht mehr erforderlich ist. Für diese vorteilhafte Ausführung wird der bekannte temperaturabhängige Widerstandsverlauf der jeweiligen Piezokeramik ausgenutzt. Wird der Strom beim Kontaktieren der Aktoren nach dem Ofenauslauf auf einen sehr geringen Wert von beispielsweise 5mA begrenzt, wird die Keramik nicht durch hohe Ströme geschädigt. Durch den vorgegebenen Strom und die sich einstellende Spannung kann der Widerstand der Keramik bestimmt werden. Erst wenn sich durch Abkühlung des Piezoaktors der Widerstand der Keramik auf einen Wert erhöht hat, der exakt oder zumindest annähernd dem Widerstand bei Curie-Temperatur entspricht, wird der Strom nicht weiter begrenzt. Daraufhin kann sich sofort und somit erst genau dann, wenn sie benötigt wird, die vorgegebene Sollspannung einstellen. Eine weitere Begrenzung des Stromes ist durch den stark gestiegenen Widerstand nicht erforderlich. Auf diese Weise wird der hohe Energieeintrag in die empfindliche Keramik durch Strom- und Spannungsbeaufschlagung vor dem eigentlichen Heißpolarisieren auf ein Minimum reduziert.

Hierbei kann auch eine Ausgestaltung als selbstregulierendes System erfolgen.

### Kurze Beschreibung der Zeichnungen

Bevorzugte Ausführungsbeispiele der Erfindung sind in der nachfolgenden Beschreibung anhand der beigefügten Zeichnungen näher erläutert. Es zeigt:
Fig. 1 einen Spannungs-, Strom- und Temperaturverlauf zur Illustration eines Verfahrens entsprechend einem ersten Ausführungsbeispiel der Erfindung;
Fig. 2 einen Spannungsverlauf zur Illustration eines Verfahrens entsprechend einem zweiten Ausführungsbeispiel der Erfindung;
Fig. 3 einen Spannungsverlauf zur Illustration eines Verfahrens entsprechend einem dritten Ausführungsbeispiel der Erfindung;
Fig. 4 ein Abfolgeschema zur Veranschaulichung eines Verfahrens entsprechend einem vierten Ausführungsbeispiel der Erfindung und
Fig. 5 einen Spannungs- und Stromverlauf zur Illustration eines Verfahrens entsprechend einem fünften Ausführungsbeispiel der Erfindung.

### Ausführungsformen der Erfindung

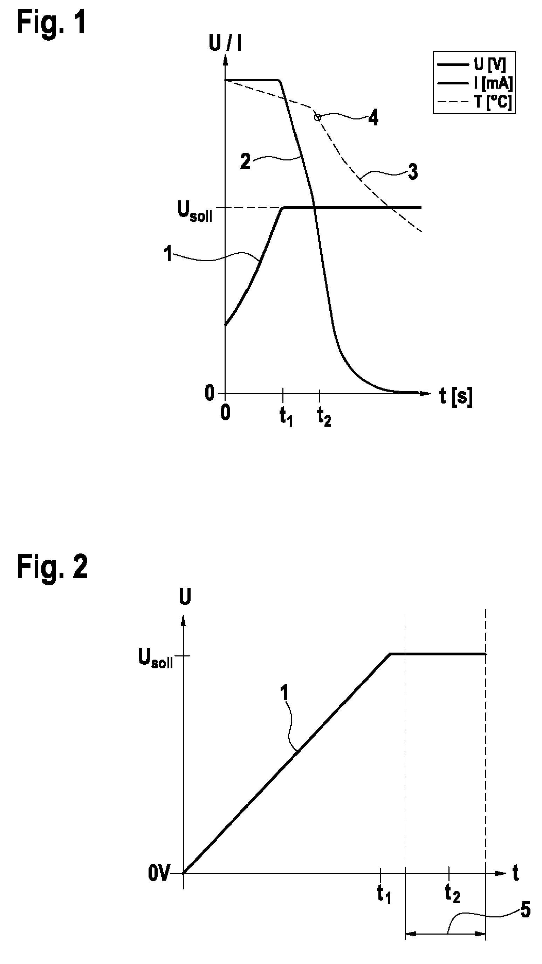

Fig. 1 zeigt ein Diagramm zum Veranschaulichen eines Verfahrens zum Heißpolarisierens eines piezokeramischen Bauelements entsprechend einem ersten Ausführungsbeispiel. Hierbei zeigt das Diagramm einen Ausschnitt des Verfahrens von einigen Sekunden. Hierbei sind über die Zeit t mehrere Signale angetragen. Das Bauelement ist aus einem piezokeramischen Material gebildet, an das eine Spannung U anlegbar ist. Der Verlauf dieser Spannung U ist in dem Diagramm durch ein Spannungssignal 1 veranschaulicht. Außerdem fließt beim Anlegen der Spannung U ein Strom durch das keramische Material, dessen Verlauf durch ein Stromsignal 2 veranschaulicht ist. Bei dem Verfahren zum Heißpolarisieren des piezokeramischen Bauelements wird das Bauelement zunächst über eine Curie-Temperatur, die formelmäßig auch als Tc bezeichnet wird, erhitzt. In dem Diagramm ist außerdem ein Temperaturverlauf des Bauelements während einer nachfolgenden Abkühlung dargestellt. Der Temperaturverlauf ist durch ein Temperatursignal 3 veranschaulicht, das beispielsweise durch einen Temperaturmessfühler gemessen wird.
Für den Heißpolarisierungsprozess mit Starttemperaturen oberhalb der Curie-Temperatur ist zu beobachten, dass bei eingeschalteter Strombegrenzung ein sprunghafter Anstieg der Spannung auf einen bestimmten Wert kleiner als eine Sollspannung Uₛₒₗₗ eintritt. Mit sinkender Temperatur T und konstanter Strombegrenzung steigt die Spannung innerhalb weniger Sekunden auf den Sollwert Uₛₒₗₗ und der Strombedarf sinkt unter den Begrenzungswert, wie es zum Zeitpunkt t₁ veranschaulicht ist. An einem Punkt 4 des Temperatursignals 3 unterschreitet die Temperatur T die Curie-Temperatur. Hierbei tritt ein Phasenübergang auf. Das Unterschreiten der Curie-Temperatur erfolgt zum Zeitpunkt t₂. Zum Zeitpunkt t₂ muss daher die Spannung U die Sollspannung Uₛₒₗₗ erreicht haben. In diesem Ausführungsbeispiel wird kurz vor dem Zeitpunkt t₂ eine Zwangskühlung des Bauteils durch externe Kühlung erreicht, so dass das Temperatursignal 3 kurz vor dem Punkt 4 einen Knick aufweist. Durch den relativ großen Strom I, der bis zum Zeitpunkt t₁ begrenzt ist, kommt es zu einem hohen Energieeintrag, der oberhalb der Curie-Temperatur keinen Beitrag zur Polarisation leisten kann.

In Abhängigkeit von der Temperatur T des Bauteils bei der Kontaktierung zu Beginn des Heißpolprozesses variiert sowohl der Wert, auf den die Spannung U sprunghaft ansteigt, als auch die Zeit t, die bis zum Erreichen der Sollspannung Uₛₒₗₗ vergeht. Durch prozessbedingt unterschiedliche Heißpol-Startspannungen schwankt der Energieeintrag in das Bauteil stark. Hierbei besteht das Problem, dass der große Ladungsträgertransport in dem keramischen Material dessen Struktur negativ beeinflussen und mechanisch schädigen kann. Folgen können das Wandern von Sauerstoffleerstellen und ein Domänenwandpinning sein, was die Schaltfähigkeit der Domänen reduziert.

Deshalb wird der überflüssige und schädigende Ladungsträgertransport in dem keramischen Material vor dem eigentlichen Heißpolarisieren reduziert und dadurch die Qualität des Heizpolprozesses gesteigert. Hierfür wird eine Spannungsregelung für das Spannungssignal 1 beziehungsweise eine genauere Stromregelung für das Stromsignal 2 bei der Durchführung des Verfahrens zum Heißpolarisieren durchgeführt. Hierbei wird unter Berücksichtigung der stark temperaturabhängigen Leitfähigkeit des keramischen Materials der Ladungsträgertransport und der Energieeintrag vor dem eigentlichen Heißpolprozess, der etwa ab dem Zeitpunkt t₂ stattfindet, stark minimiert.

Das Spannungssignal 1 wird hierbei so geführt, dass der Abstand zwischen dem Zeitpunkt t₁, an dem die Spannung U die Sollspannung Uₛₒₗₗ erreicht, und dem Zeitpunkt t₂, zu dem etwa die externe Kühlung einsetzt beziehungsweise zu dem etwa die Unterschreitung der Curie-Temperatur erfolgt, verringert wird. Speziell setzt die externe Kühlung kurz vor dem Unterschreiten der Curie-Temperatur ein. Dadurch erreicht die angelegte Spannung U die vorgegebene Sollspannung Uₛₒₗₗ beim Abkühlen erst kurz vor dem Unterschreiten der Curie-Temperatur des piezokeramischen Materials des Bauelements. Hierdurch wird ein unnötiger Energieeintrag verringert.
Bei dem Heißpolprozess kann das Bauelement auf eine Temperatur erhitzt werden, die deutlich über der Curie-Temperatur liegt, jedoch prozessbedingt beispielsweise durch Einflüsse eines Durchlaufofens, eines Ofenbesatzes, eine Belegung des Werkstückträgers und andere Einflüsse stark schwankt. Ein Bauelement mit sehr hoher Eingangstemperatur weist bis zum Erreichen der Strombegrenzung nur einen geringen sprunghaften Spannungsanstieg auf und benötigt zum Erreichen der Sollspannung Uₛₒₗₗ einen vergleichsweise langen Zeitraum, in der die Strombegrenzung greift. Ein Bauteil mit niedriger Eingangstemperatur weist hingegen einen großen Spannungsanstieg bis zum Erreichen der Strombegrenzung auf und erreicht die Sollspannung Uₛₒₗₗ sowie den gleichzeitig reduzierten Strombedarf wesentlich eher. Allerdings ist der Energieeintrag in das keramische Material in beiden Fällen unnötig hoch. Besonders kritisch ist auf Grund des hohen Ladungsträgertransports der Fall der hohen Eingangstemperatur.
Für den Polarisationsprozess ist es erforderlich, dass die Polarisationsspannung U beim Unterschreiten der Curie-Temperatur, das heißt beim Phasenübergang von der kubischen zu den koexistierenden rhomboedrischen und tetragonalen Gitterstrukturen, anliegt. Wie die Spannung U und der Strom I vor dem Phasenübergang, also bis zum Erreichen der Curie-Temperatur, verlaufen, hat prinzipiell keinen Einfluss auf die Polarisierung. Daher kann der Verlauf des Spannungssignals 1 und der Verlauf des Stromsignals 2 so angepasst werden, dass die Bauteile vor dem Heisspolarisieren einen stark minimierten und für alle Bauteile trotz gegebenenfalls unterschiedlicher Eingangstemperatur ähnlichen Energieeintrag erfahren. Durch den reduzierten Ladungsträgertransport bei sehr hohen Temperaturen oberhalb der Curie-Temperatur wird die Keramik weniger vorgeschädigt, als es durch eine einfache Strombegrenzung möglich ist.

Hierbei ist anzumerken, dass die Spannung U, der Strom I und das Temperaturprofil an die jeweilige Bauteilgeometrie des zu polarisierenden Bauteils angepasst werden.

Bei einer möglichen Ausgestaltung des Verfahrens wird eine Spannungsführung durchgeführt. Bei dieser Ausführung wird die Spannung U in einer festen Zeit von einer verschwindenden Spannung, das heißt 0 V, auf die Sollspannung Uₛₒₗₗ geführt.

Bei dieser Ausführung ist der Strombedarf aus zwei Gründen sehr gering. Der erste Grund ist, dass die heißen Bauteile für die erste Hälfte der Spannungsführung sogar einen sprunghaften Spannungsanstieg zulassen, wie es in der Fig. 1 bezüglich des Spannungssignals 1 dargestellt ist. Der zweite Grund ist, dass für die zweite Hälfte der Spannungsführung die Leitfähigkeit der Keramik durch die geringe Temperatur T bereits stark herabgesetzt ist, so dass das Bauteil bei einer gewissen Spannung U einen geringen Strombedarf I hat.

Zum Schutz des keramischen Materials kann der Strom I weiter begrenzt bleiben. Der Strom I sollte dabei jedoch nur in wenigen Fällen und für einen kurzen Moment in die Begrenzung gehen. Hierbei ist es auch möglich, dass für diesen kurzen Moment ein geringfügig höherer Strom I zugelassen wird, falls dieser auftritt. Somit ist eine vorteilhafte Führung des Stromsignals 2 möglich.

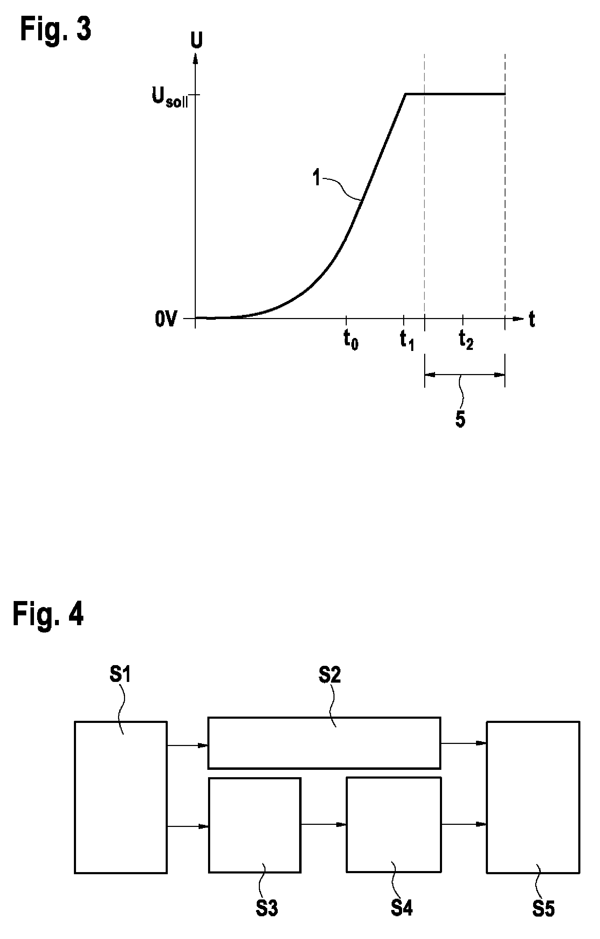

Der Verlauf des Spannungssignals 1 kann in vorteilhafter Weise abgewandelt werden. Solche Abwandlungen sind im Folgenden anhand der Fig. 2 und 3 im weiteren Detail dargestellt.

Fig. 2 zeigt ein Diagramm zur Veranschaulichung des Verfahrens entsprechend einem zweiten Ausführungsbeispiel. Hierbei ist an der Abszisse die Zeit t angetragen. An der Ordinate ist die Spannung U angetragen. In diesem Ausführungsbeispiel wird die Spannung U von einer verschwindenden Spannung, das heißt 0 V, auf die Sollspannung Uₛₒₗₗ geführt. Hierbei erreicht die Spannung U zum Zeitpunkt t₁ die Sollspannung Uₛₒₗₗ. Kurze Zeit nach dem Erreichen der Sollspannung Uₛₒₗₗ unterschreitet die Temperatur T des keramischen Materials des Bauteils die Curie-Temperatur. Dies erfolgt etwa zum Zeitpunkt t₂. Hierbei liegt der Zeitpunkt t₂ innerhalb eines Zeitfensters 5. In diesem Ausführungsbeispiel wird zunächst ein linearer Spannungsanstieg des Spannungssignals 1 bis zur Sollspannung Uₛₒₗₗ durchgeführt. Dieser Spannungsanstieg erfolgt vorzugsweise innerhalb der ersten 10 Sekunden ab der Kontaktierung bis zum Einsatz der Zwangskühlung. Gegebenenfalls kann die Anstiegszeit unter Verzögerung der Zwangskühlung verlängert werden. Dies bedeutet, dass der Zeitpunkt t zusammen mit dem Zeitfenster 5 entlang der Zeitachse t nach rechts verschoben wird. In dem Zeitfenster 5 unterschreitet das piezokeramische Material in Abhängigkeit von der Eingangstemperatur T die Curie-Temperatur, so dass die Heißpolarisation beginnt. Hierbei können unterschiedliche Bauelemente eine unterschiedliche Eingangstemperatur T aufweisen, so dass der Zeitpunkt t₂ bauteilspezifisch variiert, aber immer im Zeitfenster 5 liegt.

Fig. 3 zeigt das in Fig. 2 dargestellte Diagramm zur Illustration des Verfahrens entsprechend einem dritten Ausführungsbeispiel. In diesem Ausführungsbeispiel steigt die Spannung U beginnend von 0 V zunächst expotentiell an. Hierdurch ergibt sich ein expotentieller Spannungsanstieg. Dieser Spannungsanstieg erfolgt bis zum Zeitpunkt t₀. Dann schließt sich ein linearer Spannungsanstieg an. Somit setzt sich das Spannungssignal 1 bis zum Erreichen der Sollspannung Uₛₒₗₗ aus einem expotentiellem Abschnitt und einem linearen Abschnitt zusammen. Möglich ist es auch, dass das Spannungssignal 1 bis zum Erreichen der Sollspannung Uₛₒₗₗ als ein einziger expotentieller Anstieg ausgestaltet ist.

Bei einer weiteren möglichen Ausgestaltung des Verfahrens erfolgt eine Einzeltemperaturüberwachung der Bauelemente mit einem individuellem Anlegen der Heißpolspannung. Bei dieser Ausgestaltung wird die Temperatur T jedes Bauelements beim Kontaktieren überwacht. Die Temperaturmessung kann beispielsweise optisch oder über einen im Kontaktstift integrierten Temperaturmessfühler erfolgen. Die Spannungsbeaufschlagung wird für jedes Bauelement beim Unterschreiten einer festgelegten Temperatur, die oberhalb der Curie-Temperatur liegt, individuell gestartet. Durch den signifikant geringeren Strombedarf der abgekühlten Bauelemente kann die Sollspannung Uₛₒₗₗ mit geringerem Stromfluss schnell und noch oberhalb der Curie-Temperatur erreicht werden. Der Spannungsanstieg auf die Sollspannung Uₛₒₗₗ kann entweder über eine vorgegebene Spannungskennlinie, wie es in den Fig. 2 und 3 veranschaulicht ist, oder über eine Strombegrenzung erfolgen.

Beispielsweise kann der Spannungsanstieg beim Unterschreiten einer Temperatur T des jeweiligen Bauelements von 30 °C über der Curie-Temperatur starten, muss aber spätestens mit Einsatz der Zwangskühlung beginnen. Gegebenenfalls kann der Einsatz der Zwangskühlung verzögert werden.

Fig. 4 zeigt ein Abfolgeschema zur Illustration eines Verfahrens entsprechend einem dritten Ausführungsbeispiel. Bei diesem Ausführungsbeispiel wird eine
Einzeltemperaturüberwachung der Bauelemente mittels einer Ersatzgröße erzielt. Hierdurch kann der für die Einzeltemperaturüberwachung erforderliche Aufwand eingespart werden.

Statt der Einzeltemperaturüberwachung wird der Wert bestimmt, auf den die Spannung U bei einem sehr geringen Strom I beispielsweise einer Begrenzung auf 5 mA oder 10 mA sprunghaft ansteigt. Solch ein sprunghafter Anstieg des Spannungssignals 1 ist in der Fig. 1 bei Zeitpunkt t = 0 veranschaulicht. Da dieser Wert bei bekanntem Material einen Rückschluss auf die Temperatur T ermöglicht, kann über diese Ersatzgröße der optimale Zeitpunkt für das Anlegen beziehungsweise Erhöhen der Spannung zum Heißpolarisieren bestimmt werden. Der Strom I bleibt weiter stark reduziert, bis das keramische Material so weit abgekühlt ist, dass für das Erreichen der Sollspannung Uₛₒₗₗ eine leichte Entdrosselung des Stromes I ausreicht.

Beispielsweise kann in einem Schritt S1 die Spannungsquelle auf die Sollspannung Uₛₒₗₗ bei gleichzeitiger Begrenzung des Stroms I auf einen kleinen Strom eingestellt werden. Im Schritt S2 des Verfahrens erfolgt nur ein unwesentlicher Spannungsanstieg durch die Strombegrenzung. Hierbei kommt es nach und nach zur Abkühlung des Bauelements. Parallel zu dem Schritt S2 werden die Schritte S3 und S4 durchgeführt. Im Schritt S3 wird der sprunghafte Spannungsanstieg der Spannung U, die an das Bauelement angelegt ist, erfasst. Im Schritt S4 wird der Spannungswert auf einen Temperaturwert umgerechnet. Hierdurch kann der optimale Zeitpunkt für eine Erhöhung des zulässigen Strom I bestimmt werden. Im Schritt S5 wird zum berechneten Zeitpunkt eine geschaltete Erhöhung des Stromes I ermöglicht. Hierdurch ist ein schnelles Erreichen der Sollspannung Uₛₒₗₗ bei einer Temperatur T, die über der Curie-Temperatur liegt, mit unkritischem Stromfluss möglich.

Somit kann ein überflüssiger und schädigender Ladungsträgertransport in die Keramik reduziert werden.

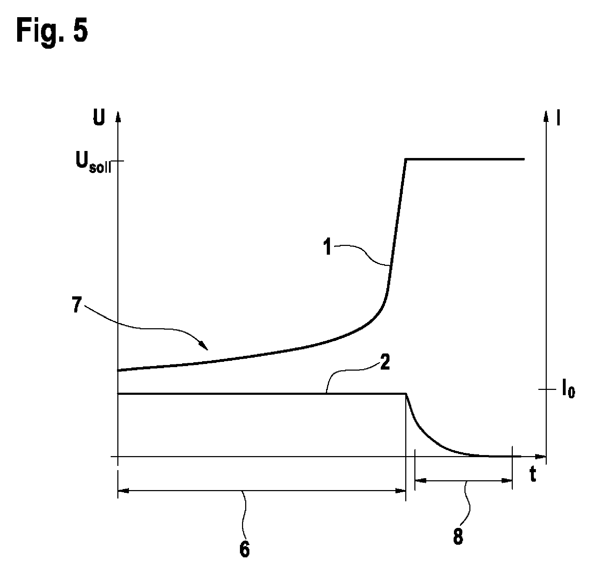

Fig. 5 zeigt ein Diagramm zur Veranschaulichung des Verfahrens zum Heißpolarisieren von piezokeramischen Bauelementen entsprechend einem fünften Ausführungsbeispiel. Hierbei sind in der Fig. 5 das Spannungssignal 1 und das Stromsignal 2 dargestellt. Hierbei kann eine Ausgestaltung realisiert werden, bei der sich ein selbstregulierendes System ergibt.

Hierfür ist beispielsweise eine Strombegrenzung auf einen Wert I₀ vorgegeben. Werden in Abhängigkeit des keramischen Materials und dessen Zustand die Strombegrenzung und der Zeitpunkt des Einsatzes der Zwangskühlung aufeinander abgestimmt, dann kann sich der Mechanismus zur Verringerung des Stromflusses oberhalb der Curie-Temperatur von selbst ausbilden. Hierbei werden zwei Effekte genutzt. Der erste Effekt ist, dass sich beim Anlegen gleicher elektrischer Felder bei fallender Temperatur T ein sinkender Strombedarf der Piezokeramik ergibt. Der zweite Effekt ist, dass sich die Temperaturunterschiede von zwei Bauelementen mit unterschiedlichen Ausgangstemperaturen bei der Abkühlung verringern.

Wird der Strom in Abhängigkeit des keramischen Materials und dessen Zustand auf einen niedrigen Wert I₀ begrenzt, dann kann sich das elektrische Feld nur sehr langsam aufbauen. Da der Anstieg der elektrischen Spannung U bei konstantem Strom I über die Abkühlung wiederum einen expotentiellen Charakter hat, wird die Sollspannung Uₛₒₗₗ jedoch auch mit geringerem Strom, dann allerdings bei geringerer Temperatur und später erreicht. Wird der Zeitpunkt der Zwangskühlung der einzelnen Bauelemente weiter verzögert, dann ergibt sich ein vorteilhafter Verlauf der Spannung U und des Stroms I für ein solches selbstregulierendes System, die durch das Spannungssignal 1 und das Stromsignal 2 der Fig. 5 veranschaulicht sind.

Durch die Verringerung der Temperaturunterschiede der Aktoren beim Abkühlen ist der Zeitpunkt des Erreichens der Sollspannung Uₛₒₗₗ zum Polarisieren zum annähernd gleichen Zeitpunkt möglich, in jedem Fall aber vor dem Phasenübergang. Die Zwangskühlung erfolgt deshalb vorzugsweise erst beim Erreichen der Sollspannung Uₛₒₗₗ.

Somit kann zunächst ein gewisser Zeitabschnitt 6 durchlaufen werden, in dem die Strombegrenzung aktiv ist. Hierbei tritt ein sprunghafter Anstieg 7 im Stromsignal 2 auf. Nach dem Erreichen der Sollspannung Uₛₒₗₗ besteht ein gewisses Zeitfenster 8, in dem das piezokeramische Material abhängig von Material und Materialzustand die Curie-Temperatur unterschreitet und die Polarisation beginnt. Außerdem setzt in dem Zeitfenster 8 auch die gegebenenfalls weiter verzögerte Zwangskühlung ein. Somit kann in vorteilhafter Weise vor dem eigentlichen Heißpolarisieren ein sich selbst regulierendes System bezüglich des Verlaufs der Spannung U und des Strom I konfiguriert werden.

Bei einer weiteren Ausführungsform des Verfahrens zum Heißpolarisieren des piezokeramischen Bauelements, insbesondere des Aktors, kann eine geregelte Strombegrenzung mit einer Widerstandsüberwachung realisiert sein.

Für diese Ausführung wird der bekannte temperaturabhängige Widerstandsverlauf der jeweiligen Piezokeramik ausgenutzt. Wird der Strom I beim Kontaktieren der Aktoren nach dem Ofenauslauf auf einen sehr geringen Wert von beispielsweise 5mA begrenzt, wird die Keramik nicht durch hohe Ströme geschädigt. Durch den vorgegebenen Strom I und die sich einstellende Spannung U kann der Widerstand der Keramik bestimmt werden. Erst wenn sich durch Abkühlung des Piezoaktors der Widerstand der Keramik auf einen Wert erhöht hat, der exakt oder zumindest annähernd dem Widerstand bei Curie-Temperatur entspricht, wird der Strom I nicht weiter begrenzt. Daraufhin kann sich sofort und somit erst genau dann, wenn sie benötigt wird, die vorgegebene Sollspannung U einstellen. Eine weitere Begrenzung des Stromes I ist durch den stark gestiegenen Widerstand nicht erforderlich. Auf diese Weise wird der hohe Energieeintrag in die empfindliche Keramik durch Strom- und Spannungsbeaufschlagung vor dem eigentlichen Heißpolarisieren auf ein Minimum reduziert. In vorteilhafter Weise wird für jeden einzelnen Aktor der Widerstand des keramischen Materials gemessen.

Hierbei kann in vorteilhafter Weise der Effekt ausgenutzt werden, dass die höchste Mobilität knapp unter der Curie-Temeratur besteht, das heißt, dass knapp unter der Curie-Temperatur die Domänen am beweglichsten sind.

Somit ist eine vorteilhafte Heißpolarisierung von mehreren Bauelementen möglich. Hierbei ergibt sich ein vorteilhafter Einfluss auf die keramische Feinstruktur der mit dem Verfahren zum Heißpolarisieren hergestellten Bauelemente.

Die Bauelemente können beispielsweise als piezoelektrische Aktoren ausgestaltet sein. Solche piezoelektrischen Aktoren weisen eine Vielzahl von keramischen Schichten und eine Vielzahl von zwischen den keramischen Schichten angeordneten Elektrodenschichten auf. Beispielsweise kann ein piezoelektrischer Aktor zur Anwendung bei einem Injektor für luftverdichtende, selbstzündende Brennkraftmaschinen hergestellt werden. Speziell betrifft dies das Gebiet der Injektoren für Brennstoffeinspritzanlagen mit einem Common-Rail. Allerdings können auch andere Multilayer-Piezoaktoren hergestellt werden, die sich insbesondere für hohe Robustheitsanforderungen eignen.

Die Erfindung ist nicht auf die beschriebenen Ausführungsbeispiele beschränkt.

## Patentansprüche

1. Verfahren zum Heißpolarisieren eines piezokeramischen Bauelements, das folgende Verfahrensschritte aufweist:
a) Erhitzen des piezokeramischen Bauelements über eine Curie-Temperatur eines piezokeramischen Materials des piezokeramischen Bauelements;
b) Abkühlen des piezokeramischen Bauelements unter die Curie-Temperatur des piezokeramischen Materials; und
c) Anlegen einer Spannung (U) an das piezokeramische Material zum Polarisieren des piezokeramischen Bauelements, wobei die angelegte Spannung (U) eine vorgegebene Sollspannung (Uₛₒₗₗ) beim Abkühlen unmittelbar vor einem Unterschreiten der Curie-Temperatur des piezokeramischen Materials erreicht, wobei
- beim Abkühlen des piezokeramischen Bauelements eine geregelte Strombegrenzung auf Grundlage einer Widerstandsüberwachung erfolgt und der Strom (I) durch das piezokeramische Bauelement beim Abkühlen zunächst auf einen Wert von 5 oder 10 mA begrenzt wird,
- auf Grundlage des vorgegebenen Stroms (I) und der sich einstellenden Spannung (U) wird der Widerstand des piezokeramischen Materials bestimmt,
- der Strom (I) wird nicht weiter begrenzt, wenn sich durch die Abkühlung des piezokeramischen Bauelements der Widerstand des keramischen Materials auf einen Wert erhöht hat, der exakt oder zumindest annähernd dem Widerstand bei Curie-Temperatur entspricht.

2. Verfahren nach Anspruch 1,
**dadurch gekennzeichnet,**
**dass** die an das piezokeramische Material angelegte Spannung in einem vorbestimmten Zeitintervall von einer zumindest näherungsweise verschwindenden Spannung auf die vorgegebene Sollspannung (Uₛₒₗₗ) geführt wird.

3. Verfahren nach Anspruch 2,
**dadurch gekennzeichnet,**
**dass** die Spannung (U) zumindest abschnittsweise mit einem zumindest näherungsweise linearen Anstieg und/oder zumindest abschnittsweise mit einem zumindest näherungsweise expotentiellen Anstieg auf die vorgegebene Sollspannung (Uₛₒₗₗ) geführt wird.

4. Verfahren nach einem der Ansprüche 1 bis 3,
**dadurch gekennzeichnet,**
**dass** eine Temperatur (T) des piezokeramischen Bauelements erfasst wird und dass in Abhängigkeit von der erfassten Temperatur (T) des piezoelektrischen Bauelements das Anlegen der Spannung (U) an das piezoelektrische Bauelement gestartet wird.

5. Verfahren nach Anspruch 4,
**dadurch gekennzeichnet,**
**dass** das Anlegen der Spannung (U) an das piezokeramische Bauelement gestartet wird, wenn die erfasste Temperatur (T) des piezokeramischen Bauelements eine vorgegebene Temperatur unterschreitet.

6. Verfahren nach einem der Ansprüche 1 bis 5,
**dadurch gekennzeichnet,**
**dass** das Abkühlen des piezokeramischen Bauelements eine externe Kühlung umfasst und dass das Anlegen der Spannung (U) an das piezokeramische Material spätestens gestartet wird, wenn die externe Kühlung beginnt.

7. Verfahren nach Anspruch 1,
**dadurch gekennzeichnet,**
**dass** der Strom (I) durch das piezokeramische Bauelement dann nicht weiter begrenzt wird, wenn eine weitere Begrenzung des Stromes (I) durch den stark gestiegenen Widerstand des piezokeramischen Materials nicht mehr erforderlich ist.

8. Verfahren nach einem der Ansprüche 1 bis 7,
**dadurch gekennzeichnet,**
**dass** mehrere piezokeramische Bauelemente zusammen heißpolarisiert werden.

## Claims

1. Method for thermal polarization of a piezoceramic device comprising the following method steps:
a) heating the piezoceramic device above a Curie temperature of a piezoceramic material of the piezoceramic device;
b) cooling the piezoceramic device below the Curie temperature of the piezoceramic material; and
c) applying a voltage (U) to the piezoceramic material for polarizing the piezoceramic device, the applied voltage (U) reaching a predetermined setpoint voltage (Uₛₑₜ) during the cooling just before the temperature goes below the Curie temperature of the piezoceramic material, wherein
- during the cooling of the piezoceramic device, a controlled current limitation takes place on the basis of a resistance monitoring and the current (I) through the piezoceramic device is initially limited during the cooling to a value of 5 or 10 mA,
- on the basis of the predetermined current (I) and the self-adjusting voltage (U), the resistance of the piezoceramic material is determined,
- the current (I) is not limited any further when, as a result of the cooling of the piezoceramic device, the resistance of the ceramic material has increased to a value that corresponds exactly or at least approximately to the resistance at the Curie temperature.

2. Method according to Claim 1,
**characterized**
**in that** the voltage applied to the piezoceramic material is adjusted in a predetermined time interval from an at least approximately negligible voltage to the predetermined setpoint voltage (Uₛₑₜ).

3. Method according to Claim 2,
**characterized**
**in that** the voltage (U) is adjusted to the predetermined setpoint voltage (Uₛₑₜ) at least in certain portions with an at least approximately linear increase and/or at least in certain portions with an at least approximately exponential increase.

4. Method according to one of Claims 1 to 3,
**characterized**
**in that** a temperature (T) of the piezoceramic device is detected and in that the application of the voltage (U) to the piezoelectric device is started in dependence on the detected temperature (T) of the piezoelectric device.

5. Method according to Claim 4,
**characterized**
**in that** the application of the voltage (U) to the piezoceramic device is started when the detected temperature (T) of the piezoceramic device goes below a predetermined temperature.

6. Method according to one of Claims 1 to 5,
**characterized**
**in that** the cooling of the piezoceramic device comprises an external cooling and in that the application of the voltage (U) to the piezoceramic material is started at the latest when the external cooling begins.

7. Method according to Claim 1,
**characterized**
**in that** the current (I) through the piezoceramic device is not limited any further when a further limitation of the current (I) is no longer required as a result of the greatly increased resistance of the piezoceramic material.

8. Method according to one of Claims 1 to 7,
**characterized**
**in that** a number of piezoceramic devices are thermally polarized together.

## Revendications

1. Procédé de polarisation thermique d'un composant piézocéramique comprenant les étapes consistant à :
a) chauffer le composant piézocéramique à une température supérieure du point de Curie d'un matériau piézocéramique du composant piézocéramique ;
b) refroidir le composant céramique à une température inférieure au point de Curie du matériau piézocéramique ; et
c) appliquer une tension (U) au matériau piézocéramique pour polariser le composant piézocéramique, dans lequel la tension (U) appliquée atteint une tension nominale (Uₛₒₗₗ) prédéterminée lors du refroidissement immédiatement avant l'abaissement en dessous du point de Curie du matériau piézocéramique, dans lequel
- lors du refroidissement du composant piézocéramique, une limitation de courant régulée est effectuée sur la base d'une surveillance de la résistance et le courant (I) passant à travers le composant piézocéramique est tout d'abord limité lors du refroidissement à une valeur de 5 ou de 10 mA,
- la résistance du matériau piézocéramique est déterminée sur la base du courant (I) prédéterminé et de la tension (U) s'établissant,
- le courant (I) cesse d'être limité lorsque la résistance du matériau céramique, lors du refroidissement du composant piézocéramique, s'élève à une valeur qui correspond exactement ou est au moins approximativement égale à la résistance observée au point de Curie.

2. Procédé selon la revendication 1,
**caractérisé en ce que** la tension appliquée au matériau piézocéramique est amenée à passer, au cours d'un intervalle de temps prédéterminé, d'une tension au moins approximativement décroissante à la tension nominale (Uₛₒₗₗ) prédéterminée.

3. Procédé selon la revendication 2,
**caractérisé en ce que** la tension (U) est amenée au moins partiellement à croître de manière au moins approximativement linéaire et/ou au moins partiellement à croître de manière au moins approximativement exponentielle jusqu'à la tension nominale (Uₛₒₗₗ) prédéterminée.

4. Procédé selon l'une quelconque des revendications 1 à 3,
**caractérisé en ce qu'**une température (T) du composant piézocéramique est détectée et **en ce que** l'application de la tension (U) au composant piézoélectrique est déclenchée en fonction de la température (T) détectée du composant piézoélectrique.

5. Procédé selon la revendication 4,
**caractérisé en ce que** l'application de la tension (U) au composant piézocéramique est déclenchée lorsque la température (T) détectée du composant piézocéramique s'abaisse en dessous d'une température prédéterminée.

6. Procédé selon l'une quelconque des revendications 1 à 5,
**caractérisé en ce que** le refroidissement du composant piézocéramique comprend un refroidissement externe et **en ce que** l'application de la tension (U) au matériau piézocéramique est déclenchée au plus tard lorsque le refroidissement externe commence.

7. Procédé selon la revendication 1,
**caractérisé en ce que** le courant (I) passant à travers le composant piézocéramique cesse d'être limité dès qu'une limitation supplémentaire du courant (I) due à la résistance fortement croissante du matériau piézocéramique n'est plus nécessaire.

8. Procédé selon l'une quelconque des revendications 1 à 7,
**caractérisé en ce qu'**une pluralité de composants piézocéramiques sont polarisés à chaud simultanément.
